# EUROPÄISCHE PATENTSCHRIFT

(11) **EP 0 802 572 B1**
(45) Veröffentlichungstag und Bekanntmachung des Hinweises auf die Patenterteilung: **05.04.2006**
(21) Anmeldenummer: 97106059.5
(22) Anmeldetag: 14.04.1997
(51) Int. Cl.: H01L 33/00

(54) **Betriebszustandsanzeige mit einem SMD-Beleuchtungselement**
Operation mode indicator with a surface-mounted-device type light source
Indicateur de mode d'operation avec source lumineuse montée en surface

(30) Priorität: 20.04.1996 DE 19615839
(43) Veröffentlichungstag der Anmeldung: 22.10.1997
(73) Patentinhaber: ABB PATENT GmbH, 68526 Ladenburg (DE)
(72) Erfinder: Figge, Hans-Joachim, 58339 Breckerfeld (DE); Stoffel, Andreas, 58339 Breckerfeld (DE)
(74) Vertreter: Stornebel, Kai

(56) Entgegenhaltungen:
- EP-A- 0 560 605
- WO-A-94/11929
- DE-A- 3 736 144
- GB-A- 2 098 714
- US-A- 5 003 357
- MOELLMER F ET AL: "Siemens SMT-TOPLED LEDs for surface mounting" SIEMENS COMPONENTS, Bd. 26, Nr. 4 / 05, 1. Oktober 1991 (1991-10-01), Seiten 147-149, XP000266913 ISSN: 0945-1137
- PATENT ABSTRACTS OF JAPAN Bd. 0181, Nr. 88 (E-1532), 31. März 1994 (1994-03-31) & JP 05 347434 A (SHARP CORP), 27. Dezember 1993 (1993-12-27)
- PATENT ABSTRACTS OF JAPAN Bd. 0141, Nr. 78 (E-0915), 10. April 1990 (1990-04-10) -& JP 02 031457 A (MATSUSHITA ELECTRIC), 1. Februar 1990 (1990-02-01)
- PATENT ABSTRACTS OF JAPAN Bd. 0123, Nr. 97 (E-672), 21. Oktober 1988 (1988-10-21) & JP 63 138788 A (RICOH CO), 10. Juni 1988 (1988-06-10)

## Beschreibung

Die Erfindung betrifft eine Betriebszustandsanzeige mit einem Gehäuse, in welchem eine surface-mounted-device-(SMD)-Leuchtdiode als Beleuchtungselement und daneben angeordnet ein Vorwiderstand integriert sind.

Es ist allgemein bekannt, in der Hausgerätetechnik, in der Unterhaltungselektronik, in der Kraftfahrzeug-Elektronik und in anderen Bereichen, wie zum Beispiel Telekommunikation, die jeweiligen Betriebszustände mit Hilfe von Leuchtsignalen anzuzeigen.

Während früher vielfach, insbesondere abhängig von dem Farbton der betreffenden Anzeige, Glühlampen oder Glimmlampen zum Einsatz vorgesehen wurden, sind inzwischen diese Leuchtmittel weitestgehend durch Leuchtdioden ersetzt worden, wobei abhängig vom Spannungsniveau den Leuchtdioden jeweils Vorwiderstände vorgeschaltet werden müssen, um deren Betriebsstrom zu begrenzen.

Leuchtdioden werden heutzutage üblicherweise in verschiedenen Helligkeitsgruppen gefertigt und jeweils in Gruppen doppelter Helligkeit zusammengefasst. Für den Anwender solcher Leuchtdioden bedeutet dies, dass für jeden Anwendungsfall spezielle Paarungen von Leuchtdiode und Vorwiderstand in den betreffenden Stücklisten anzugeben und bei der Lacierhaltung zu berücksichtigen sind.

Ferner ist bei zahlreichen Anwendungen, wo mehrere Anzeigen nebeneinander erfolgen beziehungsweise wo mehrere Teile gemeinsam montiert werden, auf eine gleichmäßige Helligkeit der Leuchtdioden zu achten. Obwohl das menschliche Auge Heiligkeitsunterschiede erst bei Abnahme der Helligkeit auf den halben Helligkeitswert beziehungsweise bei Zunahme auf wenigstens das Doppelte wahrnimmt, kann es infolge unzulässiger, größerer Toleranzen zu Anzeigefehlern kommen.

Herkömmliche Leuchtdioden besitzen heute zum Teil einen integrierten Halbleiterwiderstand als Vorwiderstand. Halbleiterwiderstände sind jedoch nicht für alle Anwendungsfälle geeignet, da sie nur jeweils eine geringe Leistung aufnehmen können und die auftretende Verlustwärme wegen ihres Gehäuses nicht abführen können. Dies kann leicht zur thermischen Zerstörung des Halbleiterwiderstands und in der Folge zur Schädigung der Leuchtdiode führen.

Ein weiterer Nachteil, der mit der Verwendung der Leuchtdioden als Beleuchtungselemente verbunden ist, beruht auf der umfangreichen Lagerhaltung, die für die Leuchtdioden unterschiedlicher Helligkeit sowie der zugehörigen Vorwiderstände beim Anwender erforderlich ist.

Aus der DE 37 36 144 A1 ist eine Leuchtdiiode mit einem Gehäuse bekannt, in dem sich ein Widerstandselement und ein LED-Chip befinden. Das Gehäuse ist rund.

Die US-5,003,357 beschreibt ein Halbleiter-Leuchtelement mit einem surface-mounted-device-Gehäuse mit einem Beleuchtungselement und einem Leuchtdiodenchip mit einem Vorwiderstand.

Aus dem Patent-Abstracts of Japan JP 05347434 ist ein lichtimitierendes Element mit einem Gehäuse beschrieben, auf dessen Unterseite ein Widerstand angeordnet ist.

Die EP 560 605 A1 beschreibt eine Lichtquelle mit einem LED-Chip, der auf einem Träger angeordnet ist. Neben der LED ist ein Widerstandselement angeordnet, sowohl das Widerstandselement als auch die LED sind in Reihe in SMD-Bauweise auf dem Träger nebeneinander angeordnet.

Ausgehend von diesem Stand der Technik ist es Aufgabe der Erfindung, ein Beleuchtungselement der eingangs genannten Art zu schaffen, das sich leicht auf die gewünschte Helligkeit einstellen lässt und eine ausreichende Betriebssicherheit aufweist.

Erfindungsgemäß wird diese Aufgabe durch die kennzeichnenden Merkmale des Anspruchs 1 gelöst. Weitere vorteilhafte Ausgestaltungen und Verbesserungen sind Gegenstand des Unteranspruches.

Entsprechend der Erfindung ist als Beleuchtungselement eine Leuchtdiode vorgesehen sowie ein laserabgleichbarer Vorwiderstand, der in das Gehäuse neben der Leuchtdiode integriert ist und zur Einstellung der Helligkeit der Leuchtdiode dient. Anschlusskontakte sind an beiden Schmalseiten des rechteckförmigen Gehäuses angeordnet, und die im Vorwiderstand erzeugte Wärme wird mittels Konvektion durch die Umgebungsluft durch eine Lüftungsöffnung in dem Gehäuse unterhalb des Vorwiderstandes abgeführt. Durch den laserabgleichbaren Widerstand kann dieser durch den jeweiligen Anwender der Leuchtdioden auf den erforderlichen Widerstandswert im Hinblick auf die von ihm gewünschte Helligkeit der Leuchtdioden mittels Laserstrahl eingestellt werden.

Mit dem erfindungsgemäßen Beleuchtungselement, das von der Leuchtdiode mit integriertem Vorwiderstand gebildet ist, entfällt der seitherige Aufwand bei der Lagerhaltung sowie der erhebliche Bestückungsaufwand, da nunmehr nur noch ein Bauteil zu montieren ist, wo zuvor wenigstens zwei Teile zu montieren waren. Auch entfällt hiermit die Erstellung unterschiedlicher Stücklisten.

Außerdem ist mit dem erfindungsgemäßen Beleuchtungselement eine Reduzierung der Heiligkeitstoleranz auf weniger als den bislang üblichen Wert 2,0 verbunden, vorzugsweise auf < 1,5, wodurch bei mehreren miteinander montierten Beleuchtungselementen die

Helligkeitsschwankungen minimiert werden.

Das erfindungsgemäßen Beleuchtungselement ist als ("surface mounted device" (SMD) ausgebildet, die bei der Montage besonders wenig Raum beansprucht, wobei auch der im Gehäuse der Leuchtdiode untergebrachte Vorwiderstand entsprechend kompakt gestaltet ist.

Gemäß einer bevorzugten Ausführungsform bildet das Gehäuse ein Vielfaches einer Grundbauform, Anhand von in der schematischen Zeichnung dargestellten Ausführungsbeispiele sollen die Erfindung, vorteilhafte Ausgestaltungen und Verbesserungen sowie besondere Vorteile der Erfindung näher erläutert und beschrieben werden.

Es zeigen:
- Fig. 1: eine Draufsicht auf ein herkömmliches Beleuchtungselement;
- Fig. 2: die Anordnung gemäß Fig. 1 von der Seite;
- Fig. 3: zum besseren Verständnis und zum Vergleich ein erstes Beleuchtungselement mit einstellbarem Vorwiderstand;
- Fig. 4: zum besseren Verständnis und zum Vergleich ein zweites 8eleuchtungselement mit einstellbarem Vorwiderstand;
- Fig. 5: zum besseren Verständnis und zum Vergleich ein drittes Beleuchtungselement, bei welchem der einstellbare Vorwiderstand um 90° gedreht angeordnet ist;
- Fig. 6: eine erste herkömmliche Schaltungsanordnung;
- Fig. 7: die Schaltungsanordnung gemäß Fig. 6 mit Beleuchtungselementen;
- Fig. 8: eine zweite herkömmliche Schaltungsanordnung;
- Fig. 9: die Schaltungsanordnung gemäß Fig. 8 mit Beleuchtungselementen;
- Fig. 10: den Schaltungsaufbau eines erfindungsgemäßen Beleuchtungselements und
- Fig. 11: die Anordnung gemäß Fig. 10 von der Seite.

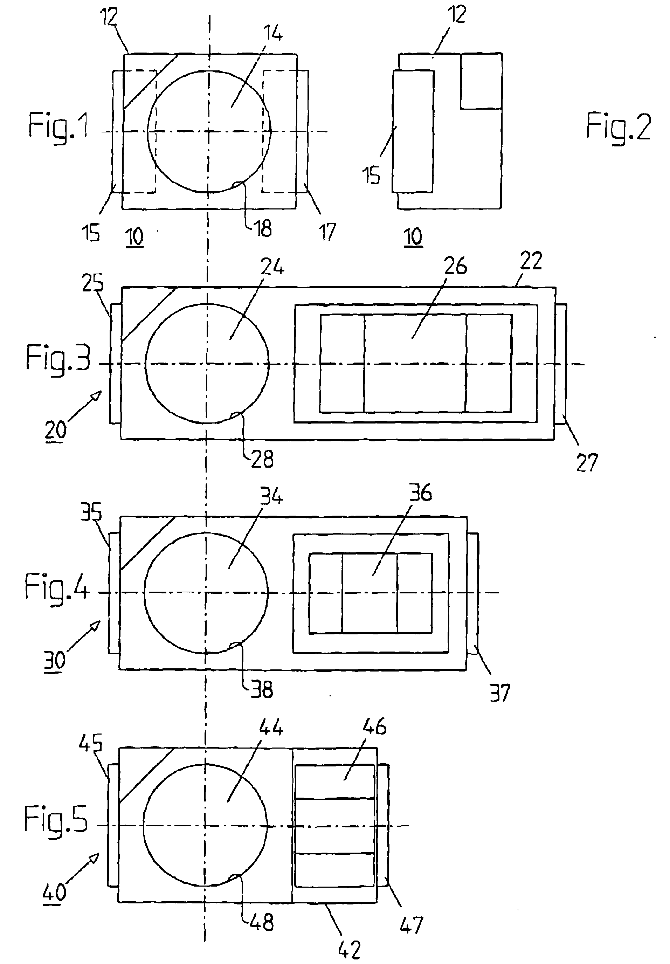

In Fig. 1 ist ein herkömmliches erfindungsgemäßes Beleuchtungselement 10 mit einem Gehäuse 12 mit einem darin angeordneten LED-Chip 14 sowie mit diesem zugeordneten Anschlußkontakten 15, 17, welche im Hinblick auf die oberflächennahe Montage als SMD-Bauteil beidseitig das Gehäuse 12 umfassen.

Das Gehäuse 12 des Beleuchtungselements 10 ist als sogenanntes Tantal-B- oder PLCC 2-Gehäuse ausgebildet. Dies hat den Vorteil, daß die Abmessungen des Beleuchtungselemnts quasi normiert sind, unabhängig von der jeweils anliegenden Versorgungsspannung. Der als Leuchtquelle dienende LED-Chip 14 ist in einem in das Gehäuse 10 eingebrachten deckseitigen Ausschnitt 18 mit einer transparenten Vergußmasse abgedeckt.

In Fig. 2 ist eine Seitenansicht des in Fig. I in Draufsicht gezeigten Beleuchtungselements 10 dargestellt, wobei anhand dieser Darstellung die Größenverhältnisse von Deckfläche einerseits und Bauteildicke ersichtlich sind.

In Fig. 3 ist zum besseren Verständnis und zum Vergleich ein erstes Beleuchtungselement 20 gezeigt, das ein der Tantal-B-Bauform ähnliches Gehäuse 22 aufweist. Das Gehäuse 22 ist gegenüber der in Fig. 1 gezeigten Baugröße um etwa das Zweieinhalbfache größer, wobei der zusätzliche Raum neben der darin angeordneten Leuchtdiode 24 zur Aufnahme eines integrierten Vorwiderstandes 26 dient. An beiden Schmalseiten des rechteckförmigen Gehäuses 22 sind wiederum Anschlußkontakte 25, 27 angeordnet.

Während wie im Stand der Technik bekannt und in Fig. 1 gezeigt, die Leuchtdiode 24 durch eine im Gehäuse 22 eingeformte kreisförmige Ausnehmung 28 nach außen strahlt, ist der daneben angeordnete Widerstand als laserabgleichbarer Widerstand ausgebildet, so daß der für die Leuchtdiode 24 erforderliche Wider-standswert im Hinblick auf die im Anwendungsfall anliegende Spannung jeweils individuell eingestellt werden kann.

In Fig. 4 ist eine ähnliche Anordnung, wie in Fig. 3 gezeigt, mit einem zweiten Beleuchtungselement 30 mit einem Gehäuse 32, mit einem LED-Chip 34 und mit einem Vorwiderstand 36 dargestellt, wobei allerdings der Widerstand 36 kleinere Abmessungen aufweist als der Widerstand 26 in Fig. 3. Auch hierbei sind an den Enden des ebenfalls rechteckförmigen Gehäuses 32 Anschlußkontakte 35, 37 angeordnet.

Für den LED-Chip 34 ist ebenfalls eine runde Ausnehmung 38 an der Oberseite des Gehäuses 32 eingeformt.

In Fig. 5 ist eine Variante eines Beleuchtungselements 40 dargestellt, das etwas kleiner ist als das in Fig. 4 gezeigte Beleuchtungselement 30, wobei hier jedoch der neben der Leuchtdiode 44 angeordnete Vorwiderstand 46 um 90° geschwenkt eingebaut ist. Hierdurch ist eine noch kleinere Baugröße des erfindungsgemäßen Beleuchtungselements 40 bei ansonsten gleichen Leistungsdaten möglich.

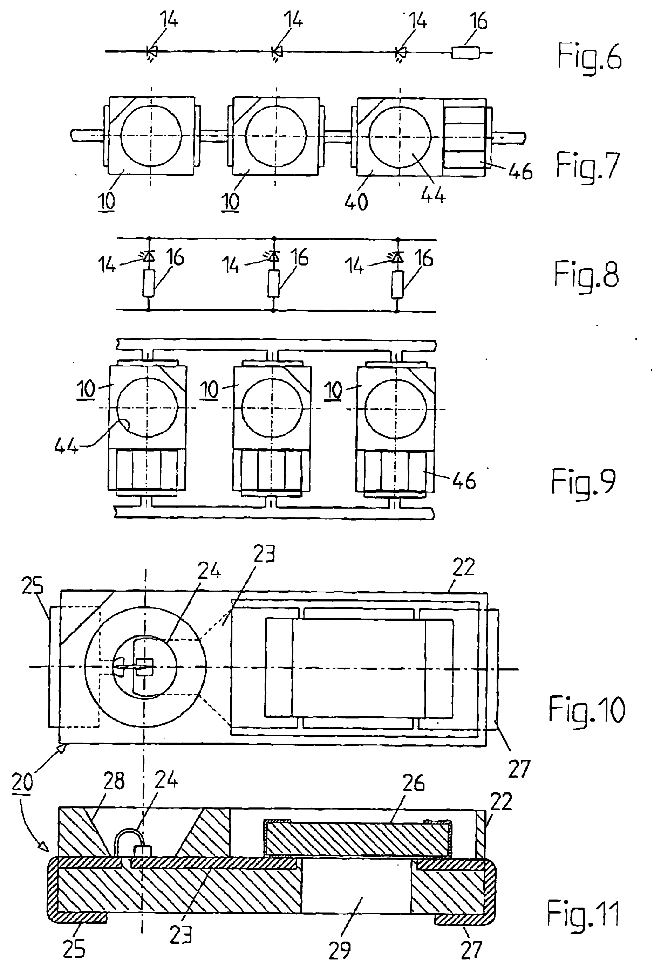

In Fig. 6 ist ein erstes Schaltungsbeispiel für eine herkömmliche Serienschaltung von drei Leuchtdioden 14 und einem Vorwiderstand 16 gezeigt, wie sie allgemein verbreitet zum Einsatz kommt.

In Fig. 7 ist diese Serienschaltung mit zwei herkömmlichen Beleuchtungselementen 10 und 40 mit abgleichbarem Vorwiderstand 46 nachgebildet, wodurch sich der Montagebedarf von zuvor vier Bauteilen auf nunmehr drei Bauteile reduziert.

In Fig. 8 ist ein zweites Schaltungsbeispiel für eine herkömmliche Parallelschaltung von drei Leuchtdioden 14 und ihren zugeordneten Vorwiderständen 16 dargestellt.

Fig. 9 zeigt eine Parallelschaltung entsprechend der in Fig. 8 gezeigten, die mit den Beleuchtungselementen 40 realisiert ist. Da hierbei der zugeordnete Vorwiderstand 46 jeweils im Gehäuse 42 des Beleuchtungselements 40 gemeinsam mit dem LED-Chip 44 integriert ist, resultieren nunmehr nur noch drei zu montierende Teile, das heißt der erforderliche Montageaufwand ist um die Hälfte verringert.

In Fig. 10 ist ein erfindungsgemäßes Beleuchtungselement 20 in Draufsicht dargestellt, so daß sowohl der LED-Chip 24 als auch der zugeordnete Vorwiderstand 26 sowie deren Kontaktbahn 23 zueinander und die Anschlußkontakte 25, 27 zu erkennen sind.

Fig. 11 zeigt die in Fig. 10 dargestellte Anordnung im Längschnitt von der Seite. Insbesondere sind in dieser Ansicht neben dem LED-Chip 24, dem Vorwiderstand 26, der Kontaktbahn 23 und Anschlußkontakten 25, 27 und der Ausnehmung 28 eine Lüftungsöffnung 29 an der Unterseite unterhalb des Vorwiderstandes 26 zu erkennen. Durch diese Lüftungsöffnung 29 kann im Vorwiderstand 26 erzeugte Wärme mittels Konvektion durch die Umgebungsluft abgeführt werden. Hierdurch ist eine bessere Leistungsausnutzung möglich.

## Patentansprüche

1. Betriebszustandsanzeige mit einem Beleuchtungselement (20) mit einem rechteckigen surface-mounted-device (SMD)-Gehäuse (22), in welchem ein Leuchtdioden-Chip (24) und daneben angeordnet ein Vorwiderstand (26) integriert sind, **dadurch gekennzeichnet, dass** als Vorwiderstand (26) ein laserabgleichbarer Widerstand vorgesehen ist, wobei Anschlusskontakte (25, 27) an beiden Schmalseiten des rechteckförmigen Gehäuses (22) angeordnet sind und die im Vorwiderstand erzeugte Wärme mittels Konvektion durch die Umgebungsluft durch eine Lüftungsöffnung (29) in dem Gehäuse (22) unterhalb des Vorwiderstandes (26) abgeführt wird.

## Claims

1. Operating mode indicator having a lighting element (20) with a rectangular surface mounted device (SMD) housing (22) in which a light-emitting diode chip (24) and a series resistor (26), which is arranged next to the said chip, are integrated, **characterized in that** the series resistor (26) provided is a laser-adjustable resistor, with connection contacts (25, 27) being arranged on the two narrow sides of the rectangular housing (22), and the heat generated in the series resistor being dissipated beneath the series resistor (26) through a ventilation opening (29) in the housing (22) by means of convection through the ambient air.

## Revendications

1. Indicateur d'état de fonctionnement comprenant un élément lumineux (20) comportant un boitier (22) rectangulaire du type dispositif monté en surface (SMD), dans lequel sont intégrées une puce à diode électroluminescente (24) et une résistance série (26) agencée à coté de celle-ci, **caractérisé en ce qu'**il est prévu comme résistance série (26) une résistance ajustable par laser, des contacts de raccordement (25, 27) étant disposés sur les deux petits cotés du boîtier rectangulaire (22) et la chaleur produite dans la résistance série est évacuée par convection par l'air ambiant à travers une ouverture d'aération (29) ménagée dans le boitier (22) en dessous de la résistance série (26).
